# EUROPEAN PATENT APPLICATION

(11) **EP 0 708 371 A2**
(43) Date of publication of application: **24.04.1996**
(21) Application number: 95116371.6
(22) Date of filing: 17.10.1995
(51) Int. Cl.: G03F 7/07, G03C 8/06

(54) **Additive for improving the performance of diffusion transfer printing plates**

(30) Priority: 18.10.1994 US 324733
(71) Applicant: MINNESOTA MINING AND MANUFACTURING COMPANY, St. Paul, Minnesota 55133-3427 (US)
(72) Inventor: Weeks, Michael G, c/o Minnesota Mining and Man. Co, Saint Paul, Minnesota 55133-3427 (US)
(74) Representative: VOSSIUS & PARTNER

(57) **Abstract**

A visible radiation sensitive photosensitive element which can be exposed to radiation between 420 and 700 nm and developed by diffusion transfer processes to form a lithographic printing plate, said element comprising:
a) a support layer,
b) a negative acting silver halide emulsion layer spectrally sensitized to radiation between the wavelengths of 450 to 700 nm on said support layer, and
c) a physical development nucleation layer comprising particles on said silver halide emulsion layer,
   wherein silver halide emulsion layer contains a Dmin stabilizing effective amount of at least one bis-triazinylaminostilbene.

## Description

This invention relates to a photosensitive element which upon radiation exposure and wet development can be made into a lithographic printing plate by the silver complex diffusion transfer process. In particular, this invention relates to additives in the layers of the photosensitive element which improve the sensitometric performance of the photosensitive platemaking element.

Photosensitive media which can produce lithographic printing plates are well known in the art as represented by U.S. Pat. Nos. 3,870,469; 4,134,769; 4,621,041; 4,160,670; 4,784,933; 4,510,228; 5,202,218; and 5,281,506. These patents disclose printing plates which are made by the exposure of a photosensitive medium and the formation of a silver layer on the surface of the medium to differentially hold or repel inks. The media essentially comprise a substrate, a negative-acting silver halide emulsion layer, and a surface receptor layer which has deposition nuclei (e.g., palladium particles) in the receptor layer. Upon exposure of the silver halide emulsion layer, the exposed photosensitive element is developed with black and white developing agents in the presence of a silver halide solvent (e.g., thiosulfate, thiocyanate, aminoalkanols, etc.). The silver halide is removed where not irradiated in the silver halide emulsion layer by dissolution in the solvent and silver ion migrates to the surface of the receptor layer where the silver halide in solution is precipitated as metallic silver onto the nucleation (e.g., palladium) particles in an imagewise manner to form a printing plate surface. The silver halide solvent may be at least in part present within the photosensitive element and/or the developing solution.

U.S. Pat. No. 2,875,058 discloses the use of bis-triazinylaminostilbenes (also known in the art by an associated tradename, "Leucophors") in red or infrared spectrally sensitized silver halide emulsions as sensitizers or supersensitizers with defined classes of spectral sensitizing dyes. This U.S. Pat. No. 2,875,058 also refers to the use of some of these compounds in other photographic configurations with other classes of spectral sensitizing dyes (e.g., U.S. Pat. Nos. 2,171,427; 2,473,475; 2,595,030; and 2,660,578). U.S. Pat. No. 3,695,888 shows similar effects for that class of sensitizing compound with tricarbocyanine infrared spectral sensitizing dyes.

U.S. Pat. Nos. 4,596,767 and 4,677,053 disclose the use of Bis-pyrimidinyl- and Bis-triazinylaminostilbenes in conjunction with benzothiazolium analogs to supersensitize and improve the stability of coating solutions in their wet state before coating for infrared sensitive silver halide emulsions. U.S. Pat. No. 4,536,473 shows similar classes of stilbene compounds in the presence of a water-soluble bromide.

U.S. Pat. No. 4,770,961 discloses the use of bis-triazinylaminostilbenes in infrared spectrally sensitized diffusion transfer printing plates.

The present invention describes a photosensitive element capable of generating a lithographic printing plate upon exposure and diffusion transfer development. The element comprises a substrate having on one surface thereof a negative-acting silver halide emulsion layer and a deposition nuclei surface layer (also referred to as a physical development nucleation layer) over the silver halide emulsion coated substrate. Inclusion of bis-pyrimidinyl- or bis-triazinylaminostilbenes to the element improves the speed and aging stability (against increasing Dmin) for the photosensitive element.

Thus, one subject matter of the invention is a visible radiation sensitive element which can be exposed to radiation between 420 and 700 nm and developed by a diffusion transfer process to form a lithographic printing plate, said element comprising:
a) a support layer,
b) a negative acting silver halide emulsion layer spectrally sensitized to radiation between the wavelengths of 420 to 700 nm on said support layer, and
c) a physical development nucleation layer comprising particles on said silver halide emulsion layer,
   wherein the silver halide emulsion layer contains a Dmin stabilizing effective amount of at least one bis-pyrimidinyl- or bis-triazinylaminostilbene.

Preferably said silver halide emulsion is spectrally sensitized to wavelengths between 440 and 600 nm.

Preferably said silver halide emulsion comprises a ruthenium and/or iridium doped silver halide emulsion.

A further subject matter of the invention is a method of manufacturing a photosensitive element which can be exposed and developed by diffusion transfer processes to form a lithographic printing plate, said method comprising the steps of:
a) providing a support layer,
b) coating a negative acting silver halide emulsion layer spectrally sensitized to wavelengths between 420 and 700 nm onto said support layer, and
c) coating a physical development nucleation layer comprising particles onto said silver halide emulsion layer,
   wherein the coating of said physical development nucleation layer is performed with a coating composition which is at a temperature above 0°C and below 35°C and said emulsion layer contains a Dmin stabilizing effective amount of at least one bis-pyrimidinyl- or bis-triazinylaminostilbene.

Said temperature is preferably between 0.1 and 30°C.

Another subject matter of the invention is a method of making a lithographic printing plate that comprises the steps of:
a) imagewise exposing a unitary, light sensitive element made by the process mentioned above which consists of a support, at least one negative acting light sensitive silver halide layer and a surface physical development nucleating layer, said construction containing a developing agent and electron transfer agent in one or more layers; and
b) processing said printing plate in a diffusion transfer alkaline activator solution.

In a preferred embodyment said diffusion transfer alkaline activator further comprises ascorbic acid or a salt thereof.

Still another subject matter of the invention is a method of making a lithographic printing plate that comprises the steps of:
a) imagewise exposing a unitary, light sensitive element mentioned above; and
b) processing said printing plate in a diffusion transfer alkaline activator solution.

The bis-pyrimidinyl- and bis-triazinylaminostilbenes used according to the invention are known compounds and many of them are commercially available under the designation "Leucophors" recited in the specification and the examples.

The present invention relates to a photosensitive element which can be developed into a lithographic printing plate by the diffusion transfer process. The plate is made from the photosensitive element by imagewise exposing a single sheet lithographic plate material consisting of a preferably flexible support, having thereon at least a light sensitive silver halide layer and a physical development nucleating surface layer. The lithographic plate is then processed in a diffusion transfer type alkaline activator and/or developer solution. The photosensitive element of this invention contains a stabilizing (against Dmin increases) effective amount of at least one bis-pyrimidinyl- or bis-triazinylaminostilbene in the emulsion layer or physical development layer. It is preferred to add the bis-pyrimidinyl- or bis-triazinylaminostilbene compounds directly with the coating solution of the emulsion layer since its best performance is tied to its activity in this layer. Coating these compounds in other layers may require larger amounts to assure that the compounds migrate in effective amounts into the emulsion layer.

The bis-pyrimidinyl- or bis-triazinylaminostilbenes useful in the present invention may be represented by the formula: 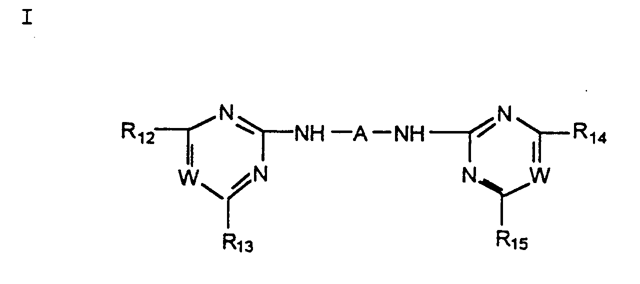
In the general formula, A represents a divalent aromatic residue which may contain an -SO₃M group (M represents a hydrogen atom or a cation such as sodium or potassium), with the proviso that when R₁₂-R₁₅ do not contain an -SO₃M group, A contains an -SO₃M group, R₁₂-R₁₅ represent a hydrogen atom, hydroxy group, aryloxy group (e.g., phenoxy, naphtoxy, o-tolyloxy or p-sulfophenoxy), heterocyclic ring (e.g., morpholinyl or piperidyl), alkylthio group (e.g., methylthio or ethylthio), heterocyclicthio group (e.g., benzothiazolylthio or benzoimidazolylthio), arylthio group (e.g. phenylthio or tolylthio), amino group, alkylamino group or arylamino group (e.g., methylamino, ethylamino, diethylamino, β-hydroxyethylamino or β-sulfoethylamino, o-, m- or p-sulfoamino, o-, m- or p-toluidino, o-, m- or p-carboxylamino, o-, m- or p-chloroamino, o-acetaminoamino, hydroxyamino, naphthylamino or sulfonaphthylamino), heterocyclicamino group (e.g. 2-benzothiazolylamino or 2-piridylamino), mercapto group, or haloalkyl group or alkoxy group; W represents -CH= or -N=; preferably -CH=, and examples of A are as follows: 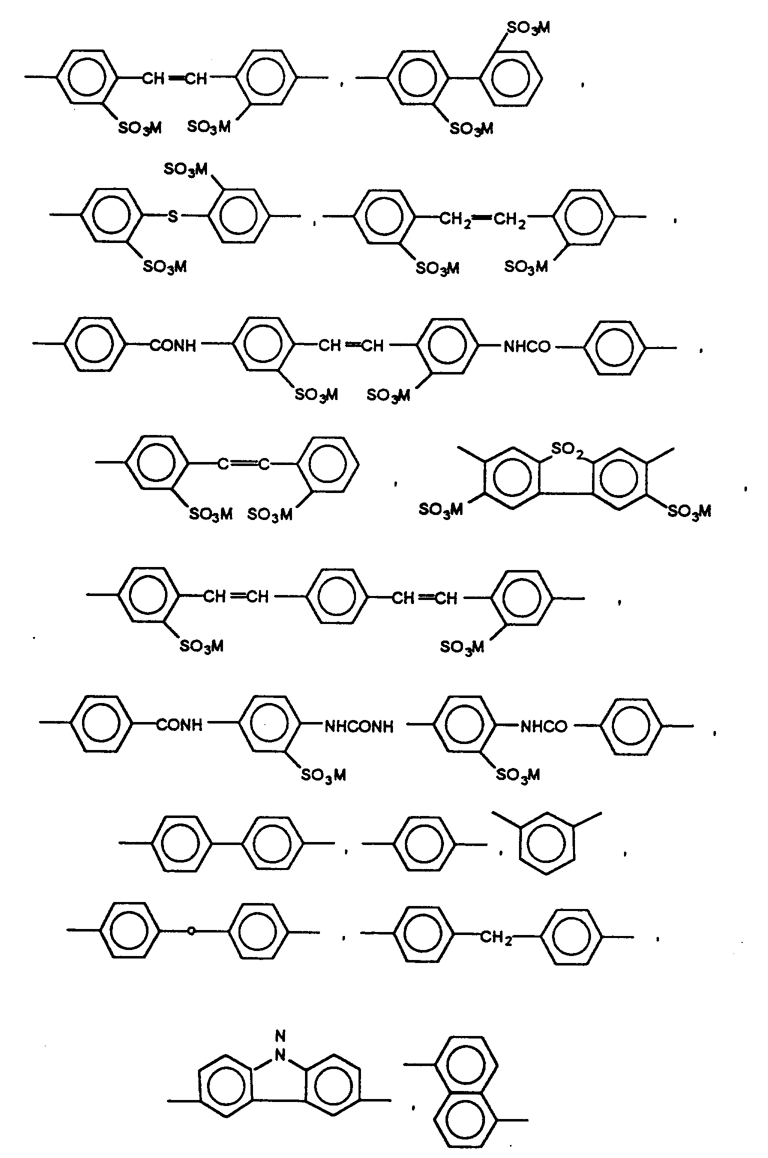
Typical examples of the useful bis-pyrimidinyl-and bis-triazinylaminostilbenes are shown below:
Disodium 4,4'-bis[4,6-di(benzothiazolyl-2-thio)-pyrimidine-2-ylamino]stilbene-2,2'disulfonate
Disodium 4,4'-bis[4,6-di(benzothiazolyl-2-amino)-pyrimidine-2-ylamino]stilbene-2,2'-disulfonate
Disodium 4,4'-bis[4,6-di(naphthyl-2-oxy)pyrimidine-2-ylamino]stilbene-2,2'-disulfonate
Disodium 4,4'-bis[4,6-di(napthyl-2-oxy)pyrimidine-2-ylamino]dibenzyl-2,2'-disulfonate
Disodium 4,4'-bis(4,6-dianilinopyrimidine-2-ylamino)stilbene-2,2'-disulfonate
Disodium 4,4'-bis[4-chloro-6-(2-napthyloxy)-pyrimidine-2-ylamino]biphenyl-2,2'-disulfonate
Disodium 4,4'-bis[4,6-di)1-phenyltetrazolyl-5-thio)pyrimidine-2-ylamino]stilbene-2,2'-disulfonate
Disodium 4,4'-bis[4,6-di(benzoimidazolyl-2-thio)-pyrimidine-2-ylamino]stilbene-2,2'-disulfonate
Disodium 4,4'-bis(4,6-diphenylthiopyrimidine-2-ylamino)stilbene-2,2'-disulfonate
Disodium 4,4'-bis(4,6-diphenylthiopyrimidine-2-ylamino)stilbene-2,2'-disulfonate
Disodium 4,4'-bis(4,6-dimercaptopyrimidine-2-ylamino)triphenyl-2,2'-disulfonate
Disodium 4,4'-bis(4,6-dianilino-triazine-2-ylamino)stilbene-2,2'-disulfonate
Disodium 4,4'-bis(4-anilino-6-hydroxy-triazine-2-ylamino)stilbene-2,2'-disulfonate
Disodium 4,4'-bis(4-naphthylamino-6-anilinotriazine-2-ylamino)stilbene-2,2'-disulfonate.

Any compound represented by the general formula I may be added to the photosensitive layer. Addition of two or more of the compounds represented by the general formula I may be desirable.

Which compound is more effective depends on the kinds of the sensitizing dyes and the compounds and combinations thereof.

The amount of the compound represented by the general formula I which is added to the emulsion is 1 x 10⁻⁴-3 x 10¹ mole, preferably 5 x 10⁻⁴-2 x 10¹ more per 1 mole of silver halide.

In the present invention a single sheet construction is described which comprises a support, on which an optional anti-halation layer, an emulsion layer and a physical nucleating receptor layer are provided. Following imagewise exposure and diffusion transfer development, the exposed area develops out as a black silver image, while the unexposed silver halide subsequently diffuses through to the receptor layer. The physical developing nuclei in the receptor layer in combination with developer reduces the solubilized silver halide to a metallic silver, optionally in the presence of a toning agent.

As described in various embodiments, e.g., U.S. Pat. Nos. 3,728,114, 4,160,670, 4,361,635 and EP 375,159, the product produced by such a process can function as a lithographic printing plate due to the oleophilic nature of the complexed silver in the receptor layer and the hydrophilic emulsion layer. However, a very rapid development process is required to reduce exposed areas into non-diffusing silver images before the silver halide solvent can take effect. The greater the differentiation between the (unexposed) complexed silver and the (exposed) developed image area, the better the printing quality will be. To achieve this goal, a very active chemistry is required.

The photosensitive elements of the present invention are preferably made by first providing an appropriate support layer, e.g., paper, treated or coated paper, polymeric film such as polyester film base (e.g., polyethyleneterephthalate or polyethylenenaphthalate), polycarbonate, cellulosic bases (such as cellulose acetate or cellulose triacetate), composite films, metals, metallized paper or metal/paper laminates and other available materials. These support bases may be primed or otherwise treated to improve adhesion and/or optical qualities of the support base as by flame treatment, corona discharge, ablation, quasiamorphization or sputtering. The support base may be provided with an antihalation layer (on either or both sides of the base), slip layer (on the backside), conductive layer (e.g., antistatic layer), or other beneficial layer(s). The silver halide emulsion layer is deposited on the support (coated or not with other layers) and then the silver deposition nucleation layer is coated onto the silver halide emulsion layer.

A preferred step in the manufacture of the photosensitive element of present invention is controlling the temperature of the receptor layer (or silver deposition nucleating layer) coating solution as it is applied to the silver halide emulsion layer coated support layer. The temperature of the receptor layer coating solution just before it contacts the silver halide emulsion layer should be within the temperature range of above 0 and below 35°C. Preferably the temperature range is between 0.1 to 30°C, more preferably between 0.1 and 20°C, still more preferably between 0.1 and 15°C, and most preferably between 0.1 and 10°C. Performing the coating step of the silver deposition nucleating layer at these temperatures has been found to additionally improve the speed and increase the contrast of the photosensitive element.

The terms "activator," "spiked activator," and "developer" have accepted meanings within the diffusion transfer printing plate art. An activator is a solution (free of such large levels of developing agent which is normally necessary to develop a diffusion transfer printing plate system, e.g., less than 5 grams per liter of developing agent, particularly polyhydroxybenzene or aminophenol developing agents) which activates the developing agent inactively residing in the printing plate. A spiked activator is an activating solution containing an amount of developing agent ordinarily considered far insufficient to actively develop diffusion transfer printing plates, but sufficient to make the activator solution initiate development more quickly and more intensely. A developer solution contains sufficient developer within the solution to actively develop a diffusion transfer printing plate (whether or not developer is present in the layers of the printing plate).

It is preferred to have a backside coat and at least an undercoat layer on the face-side of said support, usually comprising a hydrophilic polymer, which may also contain dyes or pigments to provide anti-halation or impart certain physical characteristics such as low curl or colored appearance.

The preferred hydrophilic polymer is gelatin, especially an inert deionized ossein type gelatin, and may be combined with hydrophilic binders such as starch, albumin, sodium alginate, hydroxyalkylcellulose, gum arabic, polyvinyl alcohol, polyvinyl pyrrolidone, carboxymethylcellulose, polyacrylamide or copolymers of styrene-maleic anhydride or polyvinyl methyl ether-maleic anhydride. The preferred anti-halation pigment in the undercoat layer is carbon black though other dyes or pigments that absorb at the wavelength of the imaging light source may also be used.

Included in both the back-side and face-side underlayer are coating aids such as surfactants, antistatic agents, matting agents, anti-tack agents and hardening compounds for said hydrophilic binder.

Examples of surfactants include non-ionic surface active agents such as saponin, alkylene oxide derivatives, fluorinated surfactants, glycidol derivatives, fatty acid esters of polyhydric alcohols and alkyl esters of sugars, anionic surface active agents having an acidic group such as carboxyl, sulfo, phosphor, sulfuric acid ester or phosphoric acid ester group, cationic surface active agents such as amino acids, aminoalkylsulfonic acids, aminosulfonic or phosphoric acid esters, alkylbetaines, amine oxides, alkylamine salts, aliphatic or aromatic quaternary ammonium or phosphoric salts, heterocyclic quaternary ammonium and aliphatic or heterocyclic ring-containing phosphonium or sulfonium salts. The matting agent may include silica, colloidal silica, polymeric beads, glass powder or starch powder.

The hardening agents may include organic and/or inorganic compounds for example: chromium or aluminum salts, aldehydes, N-methylol compounds, dioxane derivatives, active vinyl compounds such as triacryloylhexahydro-S-triazines or vinylsulfones, active halogen compounds such as dichlorohydroxy-S-triazines, or mucohalogenic acids.

Such materials as described above may also be utilized in the light sensitive silver halide layer.

The silver halide used in this invention may consist of silver chloride, silver bromide, silver iodide, silver chlorobromide, silver bromoiodide or mixtures thereof. Included in the silver halide are preferably dopants from Group VIII of the Periodic Table, such as rhodium, ruthenium, iridium or mixtures thereof in the range 10⁻³ to 10⁻⁸ mole per mole of silver. The crystalline form of the silver halide may be monodispersed or polydispersed and may also be of the core-shell or tablet type grains. The preferred embodiment of the present invention is a 0.2-0.3 micron ruthenium-iridium doped monodispersed silver chlorobromide emulsion containing at least 60% chloride.

These emulsions can be chemically sensitized by known methods, for example alone or in combination with: sulfur sensitization as described in U.S. Pat. Nos. 1,574,944, 2,278,947, 2,410,689, 3,189,458 or 3,501,313; gold sensitization as disclosed in U.S. Pat. Nos. 2,597,856, 2,597,915 or 2,399,083; reduction sensitization as described in U.S. Pat. Nos. 2,518,698, 2,521,925, 2,487,850 or 2,6694,637. The photographic emulsions used in the present invention may be further sensitized with quaternary ammonium or phosphonium salts, thioether compounds, polyethylene oxide derivatives or diketones as disclosed in U.S. Pat. Nos. 2,708,162, 3,046,132, 3,046,133, 3,046,134 or 3,046,135.

The photographic emulsion of the present invention may be spectrally sensitized to any wavelength in either the visible (e.g., 420-700 nm; preferably 450-680 nm), or ultraviolet (e.g., 230-400 nm) portion of the electromagnetic spectrum by methods known to those skilled in the art. Preferred ranges of spectral sensitization include 620-680 nm, 630-670 nm, 450-600 nm, and 520-590 nm). Examples of spectral sensitizers used in the present invention may include anionic, cationic, betaine, cyanine, merocyanine or other sensitizing dyes well known in the photographic art.

The photographic emulsion layer may contain various compounds to prevent fogging of the light sensitive material of the present invention during preparation, storage or during processing. Such antifoggants and stabilizers may include azoles such as benzothiazolium salts, nitroindazoles, triazoles and benzimidazoles; heterocyclic mercapto compounds such as mercaptothiazoles, mercaptobenzothiazoles, mercaptobenzimidazoles, mercaptothiadiazoles or mercaptopyrimidines; thioketo compounds such as oxazolinthione; azaindenes such as tetraazindenes; benzenethiosulfonic acids or benzenesulfinic acids.

The receptor layer provided above said emulsion layer contains physical development nuclei, which may be fine particles of metals such as silver, bismuth, antimony, cadmium, cobalt, lead, nickel, palladium, rhodium, gold, platinum and iron, or sulfides, polysulfides or selenides of these metals, or mixtures thereof. The receptor layer may also contain adjuvants such as binders, coating aids, antistatic compounds and hardeners, similar to the examples described in the other coated layers.

As mentioned previously, to differentiate the oleophilic from hydrophilic areas of the plate material, the diffusion transfer process requires an extremely active chemistry that can fully develop out the imaged areas before the silver halide solvent can take effect. One way to increase activity is to increase the alkalinity of the chemistry. However, under such conditions, the developing agent and electron transfer agent may undergo rapid oxidation, thereby adversely affecting image quality and significantly reducing chemistry life. These limitations may be overcome by incorporating the developing agents into the lithographic plate, and subsequently processing in an alkaline activator solution. Developing agents may include polyhydroxybenzenes, such as hydroquinone and electron transfer agents such as 1-phenyl-3-pyrazolidone.

The alkaline activating solution may also contain water soluble alkali metal hydroxides, such as sodium or potassium hydroxide; a toning or complexing agent such as a mercaptotetrazole, mercaptothiazole or a mercaptothiazoline; a silver halide solvent such as thiocyanate or thiosulphate, electron transfer agents such as 1-phenyl-3-pyrazolidone and other anti-oxidants such as sodium or potassium sulfite. The sulfites are preferably present in an amount within the range of 15 to 100 grams sulfite/liter of developer/activator solution. Other additives may include development accelerators such as polyoxyalkylenes or quaternary ammonium salts, antifoggants such as potassium bromide or iodide, and thickening agents such as carboxymethylcellulose.

The following non-limiting examples further illustrate this invention.

### EXAMPLE 1

A lithographic printing plate was made by coating on a clear gel subbed 4 mil. (0.1 mm) polyester support:
an underlayer consisting of an aqueous carbon black dispersion in deionized inert ossein gelatin, containing 0.4 g/m² hydroquinone, 0.08 g/m² phenidone, silica and formaldehyde;
a ruthenium-iridium doped 75:25 mole% chlorobromide emulsion having an average grain size of 0.3 microns and coated at 0.7 g/m² silver;
a top coat containing palladium sol, various coating aids and a dialdehyde starch.
Emulsions 1-6 were red sensitized with 3.9 x 10⁻³ g/m² of the following dyes, with and without Leucophor BCF at a level of 6.5 x 10⁻³ g/m². The control contained 2.0 x 10⁻³ g/m² of dye, without Leucophor BCF. All samples were held for 45 minutes at 50°C prior to coating.

| **Sample#** | **Dye** | **Leucophor BCF** |
|---|---|---|
| 1 | S-5380 | No |
| 2 | S-5380 | Yes |
| 3 | S-6088 | No |
| 4 | S-6088 | Yes |
| 5 (Control) | S-6727 | No |

"Leucophor BCF", a bis-triazinylaminostilbene which is used in accordance with the present invention has the chemical formula: 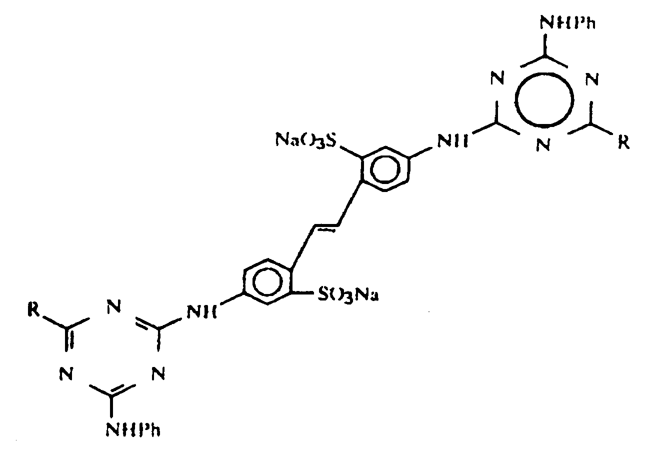
wherein R is OH.
S-5380 has the formula: 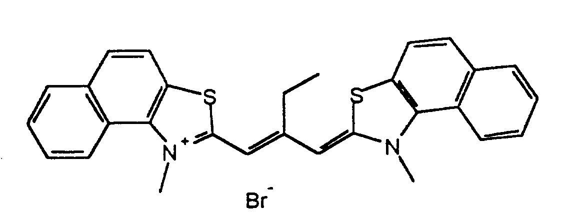
S-6088 has the formula: 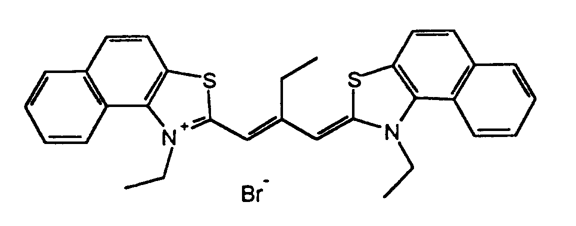
S-6727 has the formula: 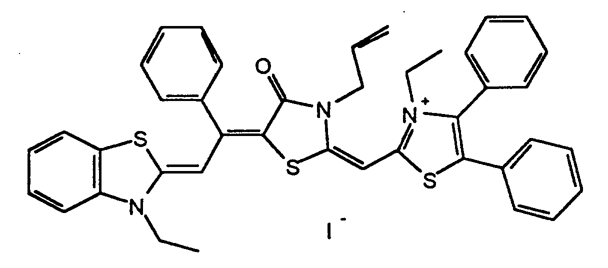
Samples were incubated for three days at 50°C, while control samples were held at room temperature. After incubation all materials were exposed on a 633 nm laser sensitometer at 2.9 mJ/m² through a 0-3 continuous tone wedge and then processed in an alkaline activator solution, followed by neutralization in 3M Onyx™ stabilizer bath.

### Alkaline Activator Solution

| | |
|---|---|
| Sodium sulfite | 42.5 g |
| Potassium hydroxide | 40.0 g |
| Sodium thiocyanate | 12.0 g |
| Trisodium phosphate | 0.2 g |
| Benzotriazole | 0.8 g |
| 1-phenyl-5-mercaptotetrazole | 0.12 g |
| Water to 1Kg | |

Sensitometric responses were measured on a computerized reflection densitometer. Speed 1 and speed 2 are relative logE values measured at 0.2 of density above Dmin and 0.2 of density below Dmax, respectively. Contrast values were taken as the gradient between these two speed points.

| **Sensitometric Response - Fresh** | | | | | |
|---|---|---|---|---|---|
| **Sample #** | **Dmin** | **Dmax** | **Speed 1** | **Speed 2** | **Contrast** |
| 1 | 0.53 | 1.28 | 1.66 | 1.11 | 0.87 |
| 2 | 0.51 | 1.29 | 1.44 | 0.98 | 1.01 |
| 3 | 0.53 | 1.27 | 1.40 | 0.86 | 0.83 |
| 4 | 0.50 | 1.28 | 1.43 | 0.99 | 1.05 |
| 5 | 0.50 | 1.30 | 1.42 | 1.01 | 1.16 |

| **Change in Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | +0.52 | -0.06 | -0.05 | -0.25 | -0.74 |
| 2 | +0.04 | -0.04 | +0.14 | +0.16 | -0.07 |
| 3 | +0.26 | -0.05 | +0.32 | +0.09 | -0.49 |
| 4 | +0.04 | -0.04 | +0.03 | +0.01 | -0.15 |
| 5 | +0.04 | -0.02 | +0.02 | +0.04 | -0.06 |

Although Leucophors are well-known infrared sensitizers, the impact on speed with the fresh samples is small and, in the case of the S-5380 dye, actually decreases speed. However, upon incubating, the stabilizing effect is quite dramatic, especially with the S-5380 and S-6088 dyes with respect to Dmin and contrast.

### EXAMPLE 2

Samples of S-5380 and S-6088 dyes from two different production lots were repeated as in Example 1. In addition, exposures were made at 2.9 mJ.m⁻² @ 633 nm and 2.0 mJ.m⁻² @ 670 nm on a laser sensitometer.

| **Sample #** | **Dye** | **Leucophor BCF** |
|---|---|---|
| 1 | S-5380 (a) | No |
| 2 | S-5380 (a) | Yes |
| 3 | S-5380 (b) | No |
| 4 | S-5380 (b) | Yes |
| 5 | S-6088 (a) | No |
| 6 | S-6088 (a) | Yes |
| 7 | S-6088 (b) | No |
| 8 | S-6088 (b) | Yes |

| **633 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.60 | 1.31 | 2.00 | 1.55 | 0.97 |
| 2 | 0.54 | 1.37 | 1.71 | 1.33 | 1.32 |
| 3 | 0.50 | 1.28 | 2.24 | 1.68 | 0.85 |
| 4 | 0.52 | 1.35 | 1.84 | 1.47 | 1.34 |
| 5 | 0.53 | 1.30 | 1.35 | 1.06 | 1.56 |
| 6 | 0.50 | 1.34 | 1.62 | 1.28 | 1.46 |
| 7 | 0.52 | 1.31 | 1.39 | 1.08 | 1.51 |
| 8 | 0.50 | 1.31 | 1.45 | 1.07 | 1.27 |

| **670 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.50 | 1.26 | 1.94 | 1.04 | 0.51 |
| 2 | 0.52 | 1.29 | 1.47 | 0.64 | 0.55 |
| 3 | 0.55 | 1.29 | 2.05 | 1.13 | 0.49 |
| 4 | 0.49 | 1.30 | 1.66 | 0.86 | 0.61 |
| 5 | 0.48 | 1.24 | 1.45 | 0.64 | 0.57 |
| 6 | 0.50 | 1.28 | 1.41 | 0.68 | 0.64 |
| 7 | 0.49 | 1.29 | 1.84 | 1.13 | 0.68 |
| 8 | 0.48 | 1.14 | 1.08 | 0.14 | 0.42 |

| **Change in 633 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | ---- | ---- | Sample Fogged | ---- | ---- |
| 2 | +0.13 | -0.12 | -0.03 | -0.51 | -0.95 |
| 3 | ---- | ---- | Sample Fogged | ---- | ---- |
| 4 | +0.13 | -0.08 | -0.05 | -0.54 | -0.91 |
| 5 | ---- | ---- | Sample Fogged | ---- | ---- |
| 6 | +0.18 | -0.07 | +0.14 | +0.09 | -0.57 |
| 7 | ---- | ---- | Sample Fogged | ---- | ---- |
| 8 | +0.04 | -0.05 | +0.12 | +0.08 | -0.26 |

| **Change in 670 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | ----- | ----- | Sample Fogged | ----- | ----- |
| 2 | +0.09 | -0.05 | +0.16 | +0.27 | -0.03 |
| 3 | ----- | ----- | Sample Fogged | ----- | ----- |
| 4 | +0.09 | -0.04 | +0.19 | +0.31 | -0.02 |
| 5 | ----- | ----- | Sample Fogged | ----- | ----- |
| 6 | +0.14 | -0.03 | +0.23 | +0.32 | -0.05 |
| 7 | ----- | ----- | Sample Fogged | ----- | ----- |
| 8 | +0.05 | +0.01 | +0.11 | +0.03 | -0.05 |

While there is some difference between dye lots, both S-5380 and S-6088 have sufficient sensitivity to be useful at both HeNe laser and red laser diode wavelengths. Interestingly, Leucophor desensitizes the S-5380 emulsion, yet with S-6088 it has a supersensitizing effect at 633 nm, no little effect at 670 nm (Sample #8/670 nm is considered an anomaly). The effect on contrast is the opposite - S-5380 contrast increases while S-6088 decreases. Also, with Leucophor BCF S-6088 is significantly more stable at 633 nm than S-5380 dye. In any event Leucophor BCF prevents total fogging of the emulsion upon incubation an either wavelength.

### EXAMPLE 3

The Leucophor BCF level in the S-5380 sensitized emulsion was studied in the amounts of 0, 3.25, 6.5 and 13.0 x 10⁻³ g/m² according to the method outlined in Example 1.

| **670 nm Sensitometric Response - Fresh** | | | | | |
|---|---|---|---|---|---|
| **Leucophor Level** | **Dmin** | **Dmax** | **Speed 1** | **Speed 2** | **Contrast** |
| 0 | 0.45 | 1.31 | 2.47 | 2.05 | 1.21 |
| 3.25 x 10⁻³ g/m² | 0.47 | 1.32 | 2.34 | 1.92 | 1.23 |
| 6.5 x 10⁻³ g/m² | 0.48 | 1.30 | 1.99 | 1.54 | 1.12 |
| 13.0 x 10⁻³ g/m² | 0.48 | 1.31 | 2.28 | 1.89 | 1.25 |

| **Change in 670 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 0 | +0.14 | -0.07 | +0.07 | -0.01 | -0.50 |
| 3.25 x 10⁻³ g/m² | +0.10 | -0.07 | +0.04 | -0.01 | -0.36 |
| 6.5 x 10⁻³ g/m² | +0.06 | -0.07 | +0.06 | -0.02 | -0.31 |
| 13.0 x 10⁻³ g/m² | +0.05 | -0.07 | +0.05 | -0.02 | -0.35 |

While there is little if any improvement in incubation stability between 6.5 and 13.0 x 10⁻³ g/m² levels of Leucophor BCF, the increased quantity minimizes the speed loss and Dmin gain associated with this dye.

### EXAMPLE 4

Coatings using dyes S-5380(a) and S-6088(a) were prepared and incubated as described in Example 2. The hold time prior to coating was increased from 45 minutes to 75 minutes at 50°C. The control, using dye S-6727, was also included. Laser sensitometer for 670 nm exposures were increased from 2.0 to 4.0 mJ/m².

| **Sample #** | **Dye** | **Leucophor BCF** |
|---|---|---|
| 1 | S-5380(a) | No |
| 2 | S-5380(a) | 6.5 x 10⁻³ g/m² |
| 3 | S-6088(a) | No |
| 4 | S-6088(a) | 6.5 x 10⁻³ g/m² |
| 5(Control) | S-6727 | No |

| **633 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.49 | 1.29 | 1.77 | 1.40 | 1.30 |
| 2 | 0.45 | 1.31 | 1.66 | 1.31 | 1.49 |
| 3 | 0.47 | 1.29 | 1.32 | 1.02 | 1.64 |
| 4 | 0.47 | 1.32 | 1.58 | 1.22 | 1.41 |
| 5 | 0.48 | 1.31 | 1.57 | 1.13 | 1.16 |

| **670 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.56 | 1.30 | 2.58 | 2.18 | 1.09 |
| 2 | 0.48 | 1.31 | 2.23 | 1.81 | 1.19 |
| 3 | 0.48 | 1.30 | 2.39 | 2.04 | 1.43 |
| 4 | 0.49 | 1.32 | 2.23 | 1.79 | 1.09 |
| 5 | ----- | ----- | No Sensitivity | ----- | ----- |

| **Change in 633 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | ----- | ----- | Fogged | ----- | ----- |
| 2 | +0.06 | -0.09 | -0.01 | -0.03 | -0.30 |
| 3 | ----- | ----- | Fogged | ----- | ----- |
| 4 | +0.06 | -0.11 | +0.02 | -0.01 | -0.37 |
| 5 | +0.03 | -0.09 | -0.03 | 0 | -0.10 |

| **Change in 670 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | ----- | ----- | Fogged | ----- | ----- |
| 2 | 0 | -0.07 | +0.08 | -0.02 | -0.28 |
| 3 | ----- | ----- | Fogged | ----- | ----- |
| 4 | +0.02 | -0.09 | +0.16 | +0.08 | -0.28 |
| 5 | ----- | ----- | No Sensitivity | ----- | ----- |

Although the control exhibits adequate sensitometric response and incubation stability at 633 nm, the lack of sensitivity at 670 nm (even though the laser sensitometer power was doubled), precludes its use in printing plates for RLD type imagesetters. Again, leucophor S-6088 increases sensitivity at 633 nm but decreases sensitivity at 670 nm. Compared to Example 2 the **△**responses are significantly reduced and, in this instance, little difference in incubation stability is observed between 633 and 670 nm exposures.

### EXAMPLE 5

In subsequent experiments it was found that the mode of dye and Leucophor addition is also dependent on the wavelength of exposure, as is demonstrated below:

| **Sample #** | **S-5380 Dye/Leucophor BCF Added** |
|---|---|
| 1 | Leucophor added, immediately followed by dye, held 45 mins. and coated. |
| 2 | Dye added, held 30 mins., Leucophor added, held 45 mins. and coated. |

| **633 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.45 | 1.24 | 1.51 | 1.04 | 1.00 |
| 2 | 0.45 | 1.23 | 1.49 | 1.06 | 1.11 |

| **670 nm Sensitometric Response - Fresh** | | | | | |
|---|---|---|---|---|---|
| **Sample #** | **Dmin** | **Dmax** | **Speed 1** | **Speed 2** | **Contrast** |
| 1 | 0.45 | 1.26 | 1.82 | 1.32 | 0.99 |
| 2 | 0.46 | 1.26 | 1.97 | 1.58 | 1.23 |

| **Change in 633 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | +0.05 | -0.05 | +0.04 | +0.07 | -0.02 |
| 2 | +0.05 | -0.04 | 0 | +0.02 | -0.02 |

| **Change in 670 nm Sensitometric Response After Oven Incubation** | | | | | |
|---|---|---|---|---|---|
| **Sample #** | **△Dmin** | **△Dmax** | **△Speed 1** | **△Speed 2** | **△Contrast** |
| 1 | +0.05 | -0.05 | +0.01 | +0.05 | -0.04 |
| 2 | +0.03 | -0.05 | +0.01 | 0 | -0.13 |

Thus, for purposes of RLD type exposures it may be preferable to add the dye before the Leucophor.

### EXAMPLE 6

Various optical brighteners were studied as per the method outlined in Example 1:

| **633 nm Sensitometric Response - Fresh** | | | | | |
|---|---|---|---|---|---|
| **Sample** | **Dmin** | **Dmax** | **Speed 1** | **Speed 2** | **Contrast** |
| Leucophor BCF | 0.49 | 1.25 | 1.76 | 1.46 | 1.53 |
| Leucophor B150 | 0.49 | 1.26 | 1.63 | 1.32 | 1.46 |
| Leucophor C-7002-U | 0.50 | 1.25 | 1.68 | 1.37 | 1.47 |
| Leucophor P306 | 0.49 | 1.25 | 1.67 | 1.34 | 1.40 |
| Leucophor BSB | 0.48 | 1.26 | 1.68 | 1.36 | 1.49 |
| Leucophor BCR | 0.49 | 1.25 | 1.76 | 1.42 | 1.33 |
| Leucophor L-Conc. | 0.51 | 1.25 | 1.76 | 1.45 | 1.46 |
| Tinopal PT | 0.48 | 1.25 | 1.66 | 1.35 | 1.50 |
| Tinopal HST | 0.45 | 1.27 | 1.64 | 1.30 | 1.46 |
| Blancophor REW-133 | 0.49 | 1.26 | 1.77 | 1.41 | 1.28 |

| **670 nm Sensitometric Response - Fresh** | | | | | |
|---|---|---|---|---|---|
| **Sample** | **Dmin** | **Dmax** | **Speed 1** | **Speed 2** | **Contrast** |
| Leucophor BCF | 0.49 | 1.28 | 2.11 | 1.76 | 1.38 |
| Leucophor B150 | 0.49 | 1.27 | 2.15 | 1.81 | 1.39 |
| Leucophor C-7002-U | 0.50 | 1.26 | 2.16 | 1.82 | 1.35 |
| Leucophor P306 | 0.50 | 1.27 | 2.21 | 1.87 | 1.35 |
| Leucophor BSB | 0.49 | 1.27 | 2.19 | 1.84 | 1.33 |
| Leucophor BCR | 0.49 | 1.27 | 2.33 | 1.96 | 1.27 |
| Leucophor L-Conc. | 0.50 | 1.27 | 2.21 | 1.88 | 1.39 |
| Tinopal PT | 0.48 | 1.27 | 2.18 | 1.84 | 1.36 |
| Tinopal HST | 0.46 | 1.27 | 2.18 | 1.84 | 1.36 |
| Blancophor REW-133 | 0.47 | 1.27 | 2.37 | 1.98 | 1.22 |

| **Change in 633 nm Sensitometric Response After Oven Incubation** | | | | | |
|---|---|---|---|---|---|
| **Sample** | **△Dmin** | **△Dmax** | **△Speed 1** | **△Speed 2** | **△Contrast** |
| Leucophor BCF | +0.09 | 0 | +0.31 | +0.16 | -0.62 |
| Leucophor B150 | +0.10 | -0.02 | +0.29 | +0.14 | -0.61 |
| Leucophor C-7002-U | +0.11 | -0.01 | +0.31 | +0.18 | -0.60 |
| Leucophor P306 | +0.12 | -0.01 | +0.31 | +0.15 | -0.63 |
| Leucophor BSB | +0.13 | -0.02 | +0.36 | +0.21 | -0.68 |
| Leucophor BCR | +0.16 | -0.01 | +0.33 | +0.15 | -0.65 |
| Leucophor L-Conc. | +0.09 | -0.01 | +0.32 | +0.18 | -0.59 |
| Tinopal PT | +0.12 | -0.01 | +0.35 | +0.15 | -0.72 |
| Tinopal HST | +0.41 | -0.02 | +0.41 | +0.22 | -0.80 |
| Blandophor REW-133 | +0.36 | 0 | +0.28 | +0.04 | -0.87 |

| **Change in 670 nm Sensitometric Response After Oven Incubation** | | | | | |
|---|---|---|---|---|---|
| **Sample** | **△Dmin** | **△Dmax** | **△Speed 1** | **△Speed 2** | **△Contrast** |
| Leucophor BCF | +0.07 | -0.03 | +0.35 | +0.19 | -0.58 |
| Leucophor B150 | +0.10 | -0.02 | +0.26 | +0.10 | -0.57 |
| Leucophor C-7002-U | +0.10 | -0.01 | +0.29 | +0.13 | -0.57 |
| Leucophor P306 | +0.10 | -0.02 | +0.32 | +0.13 | -0.61 |
| Leucophor BSB | +0.13 | -0.01 | +0.46 | +0.24 | -0.64 |
| Leucophor BCR | +0.18 | -0.02 | +0.27 | +0.09 | -0.63 |
| Leucophor L-Conc. | +0.09 | -0.02 | +0.29 | +0.16 | -0.52 |
| Tinopal PT | +0.11 | -0.02 | +0.27 | +0.13 | -0.55 |
| Tinopal HST | +0.22 | -0.03 | +0.36 | +0.19 | -0.74 |
| Blancophor REW-133 | +0.39 | -0.01 | +0.24 | -0.05 | -0.87 |

Tinopal PT and the Leucophor class of compounds exhibit significantly better antifoggant property than Tinopal HST or Blancophor REW-133.

## Claims

1. A visible radiation sensitive element which can be exposed to radiation between 420 and 700 nm and developed by a diffusion transfer process to form a lithographic printing plate, said element comprising:
a) a support layer,
b) a negative acting silver halide emulsion layer spectrally sensitized to radiation between the wavelengths of 420 to 700 nm on said support layer, and
c) a physical development nucleation layer comprising particles on said silver halide emulsion layer,
wherein the silver halide emulsion layer contains a Dmin stabilizing effective amount of at least one bis-pyrimidinyl- or bis-triazinylaminostilbene.

2. The element of claim 1 wherein said silver halide emulsion is spectrally sensitized to wavelengths between 440 and 600 nm.

3. The element of claims 1 or 2 wherein said silver halide emulsion comprises a ruthenium and/or iridium doped silver halide emulsion.

4. A method of manufacturing a photosensitive element which can be exposed and developed by diffusion transfer processes to form a lithographic printing plate, said method comprising the steps of:
a) providing a support layer,
b) coating a negative acting silver halide emulsion layer spectrally sensitized to wavelengths between 420 and 700 nm onto said support layer, and
c) coating a physical development nucleation layer comprising particles onto said silver halide emulsion layer,
wherein the coating of said physical development nucleation layer is performed with a coating composition which is at a temperature above 0°C and below 35°C and said emulsion layer contains a Dmin stabilizing effective amount of at least one bis- pyrimidinyl- or bis-triazinylaminostilbene.

5. The process of claim 4 wherein said temperature is between 0.1 and 30°C.

6. A method of making a lithographic printing plate that comprises the steps of:
a) imagewise exposing a unitary, light sensitive element made by the process of claim 4 which consists of a support, at least one negative acting light sensitive silver halide layer and a surface physical development nucleating layer, said construction containing a developing agent and electron transfer agent in one or more layers; and
b) processing said printing plate in a diffusion transfer alkaline activator solution.

7. A method according to claim 6 in which said diffusion transfer alkaline activator further comprises ascorbic acid or a salt thereof.

8. A method of making a lithographic printing plate that comprises the steps of:
a) imagewise exposing a unitary, light sensitive element of claim 1; and
b) processing said printing plate in a diffusion transfer alkaline activator solution.
